# EUROPÄISCHE PATENTSCHRIFT

(11) **EP 0 979 414 B1**
(45) Veröffentlichungstag und Bekanntmachung des Hinweises auf die Patenterteilung: **30.08.2006**
(21) Anmeldenummer: 99903611.4
(22) Anmeldetag: 08.01.1999
(51) Int. Cl.: G01R 1/067, G01B 7/34

(54) **VIELSONDENTESTKOPF UND PRÜFVERFAHREN**
MULTI-PROBE TEST HEAD AND TEST METHOD
TETE TEMOIN A SONDES MULTIPLES ET PROCEDE DE TEST

(30) Priorität: 30.01.1998 DE 19803452
(43) Veröffentlichungstag der Anmeldung: 16.02.2000
(73) Patentinhaber: NaWoTec GmbH, 64380 Rossdorf (DE)
(72) Erfinder: KOOPS, Hans, W., P., D-64372 Ober-Ramstadt (DE)
(74) Vertreter: Borchert, Uwe Rudolf
(86) Internationale Anmeldenummer: PCT/EP1999/000069
(87) Internationale Veröffentlichungsnummer: WO 1999/039215

(56) Entgegenhaltungen:
- EP-A- 0 648 999
- EP-A- 0 727 814
- US-A- 5 171 992

## Beschreibung

Die Erfindung betrifft einen Testkopf für ein Rastersondenmikroskop zum berührungslosen Prüfen von integrierten elektronischen Schaltungen.

Zur Charakterisierung und Überprüfung von integrierten Schaltkreisen auf Mikrochips werden heutzutage Rastersondenmikroskope eingesetzt, mit deren Hilfe Testspitzen zur Messung der Signalflüsse der Schaltungen in die unmittelbare Nähe bestimmter Schaltungselemente gebracht werden. Derartige Spitzen werden heutzutage durch Ätzen aus einem Drahtende in der Größenordnung von µm hergestellt. Die Testköpfe, auf welche die Testspitzen aufgebracht werden, können mit Hilfe moderner Rastersondenmikroskope mit einer Genauigkeit von wenigen nm positioniert werden. Jedoch sind aufgrund der Grobheit der verfügbaren Spitzen der exakte Ort der Spitze und der Abstand zwischen Spitze und Probe bislang nicht genau genug bestimmbar. Es ist zusätzlicher Meßaufwand zur Positionierung und definierten Zurückziehung der Spitze notwendig, um Beschädigungen zu vermeiden.

Zur Messung der gesuchten Kenngrößen einer integrierten Schaltung wird der Testkopf mit Hilfe der Mikroskopsteuerung an eine vorgegebene Stelle gerückt und die Messung vorgenommen. Sollen mehrere verschiedene Größen gemessen werden, so ist es bislang notwendig, nach jeder Messung eine für die nächste zu messende Größe geeignete Sonde an die Prüfstelle zu bewegen, bevor diese Größe gemessen werden kann.

Durch fortschreitende Miniaturisierung der Schaltkreise werden die Abmessungen der Leiterbahnen und Bauteile der Schaltungen, sowie die Intensität der in den Schaltungen im Betrieb geführten Signale immer kleiner. Ferner steigt die Frequenz, mit der moderne Mikroprozessoren betrieben werden, beständig an. Mittlerweile ist es notwendig, Signalmessungen an Schaltungsteilen mit Abmessungen in der Größenordnung von 100 nm bei Frequenzen in der Größenordnung von 1 THz vorzunehmen. Die Kapazität heutiger kapazitiver Messsonden ist für die Messung höchstfrequenter Signale zu hoch. Die bislang verfügbaren magnetfeld-empfindlichen Sonden, die zur Messung von Magnetfeldern zu Bestimmung der Ströme in den Schaltungen verwendet werden, sind ebenfalls bislang nicht mit der notwendigen Feinheit herstellbar.

In der EP 0 727 814 ist eine Abtastvorrichtung mit magnetischen oder elektrischen Sensoren offenbart, die in der Rastersondenmikroskopie eingesetzt werden kann. Die Vorrichtung zeichnet sich dadurch aus, dass der Sensor durch galvanisches Abformen einer Negativform herstellbar ist.

Aufgabe der vorliegenden-Erfindung ist es, einen Testkopf für ein Rastersondenmikroskop zur genauen und manuellen Prüfung einer modernen hochintegrierten Schaltung, sowie ein Verfahren zur genauen und schnellen Prüfung dieser Schaltung anzugeben. Die Messung mehrerer unterschiedlicher Größen an einer Messstelle soll damit ohne Verschieben des Testkopfes möglich sein. Der damit ohne Verschieben des Testkopfes möglich sein. Der Testkopf soll mit vorhandenen Gerätschaften einfach und verhältnismäßig preiswert herstellbar sein.

Diese Aufgabe wird dadurch gelöst, dass eine Gruppe von durch dreidimensionale additive Lithographie hergestellten Sonden mit wenigstens einem elektrisch isolierenden, zugespitzt endenden Körper als Rasterkraft-Sonde zur Abtastung der Topographie der Schaltung, mit wenigstens einer kapazitiven Sonde zur Messung von Signalimpulsen und mit wenigstens einer magnetfeld-empfindlichen Sonde zur Messung von elektrischen Strömen, soweit mit wenigstens einem spitz zulaufenden leitenden Körper als Feldemissions-Sonde auf einem Träger angeordnet ist, dass die Sonden auf eine zentral über der Sondengruppe gelegene Stelle gerichtet sind und dass
die leitenden Sonden sowie das Fußende der kapazitiven Sonde zum Anschluß an eine Meßschaltung mit Leiterstrukturen auf dem Träger verbunden sind. Dabei kann vorgesehen sein, daß die Rasterkraft-Sonde die anderen Sonden überragt.

Durch die Ausrichtung der Sonden um eine zentrale Stelle ist die Empfindlichkeit der Sonden in dieser Richtung am größten. Der Testkopf wird mit Hilfe der etwas vorstehenden Rasterkraft-Sonde an eine Meßstelle bewegt. Die an dieser Stelle laufenden Signale der integrierten Schaltung können dann gleichzeitig von verschiedenen Sonden gemessen werden, ohne daß der Testkopf bewegt werden muß.

Es hat sich in Versuchen als vorteilhaft herausgestellt, wenn die Teile des Testkopfes die in Unteransprüchen aufgeführten Abmessungen aufweisen.

Mittels Verfahren der dreidimensionalen additiven Lithographie können Stäbe und leitfähige Spitzen mit einer Plazierungsgenauigkeit von 5 nm unter beliebigen Neigungswinkeln auf einem Träger angeordnet werden. Desweiteren erlaubt speziell die elektronenstrahlinduzierte Deposition die Fertigung von Bögen, Scheiben mit Öffnungen oder dergleichen mit der gleichen Genauigkeit.

Bei der elektronenstrahlinduzierten Deposition wird der Dampf spezieller Substanzen auf eine Trägeroberfläche geleitet und dort mittels eines feinen Elektronenstrahls atomisiert. Die Atome lagern sich daraufhin mit der Hilfe weiterer Elektronen zu einem Festkörper aus kleinsten Kristalliten zusammen. Durch entsprechende Steuerung des Strahles lassen sich damit fast beliebig geformte Strukturen herstellen. Es ist möglich, die Strukturen aus verschiedenen Werkstoffen herzustellen. So können beispielsweise auch elektrisch leitfähige Drähte, die mit einem isolierenden Mantel umgeben sind oder außen verspiegelte lichtleitende Strukturen kleinster Abmessung gefertigt werden.

Die für die Prüfung einer integrierten Schaltung nach dem Oberbegriff notwendigen erfindungsgemäßen Sonden können mit der genannten Technik auf einer wenige Quadratmikrometer messenden Fläche, die an einem herkömmlichen Kantilever angeordnet sein kann, mit hoher Genauigkeit aufgebaut und zu einer gemeinsamen Meßstelle hin ausgerichtet werden. Mit erfindungsgemäßen Sonden werden die zur Prüfung auch hochintegrierter Schaltungen notwendigen Ortsauflösungen erreicht.

Zur Vereinfachung der Signalauswertung und der Zeitauflösung ist vorgesehen, daß eine Verstärkerschaltung mit in unmittelbarer Nachbarschaft der Sonden in dreidimensionaler Nanolithographie ausgeführten elektrischen Verstärkerröhren zur Verstärkung der von den Sonden abgegebenen Meßsignale auf dem Träger angeordnet ist.

In weiteren Unteransprüchen sind vorteilhafte Ausgestaltungen des Trägers sowie der einzelnen Sonden aufgeführt. Derartige Sonden können durch Verfahren der dreidimensionalen Lithographie hergestellt werden.

Zum Justieren des Testkopfes über einer Meßstelle ist vorgesehen, daß die Rasterkraft-Sonde berührungslos über die integrierte Schaltung bis zum vorgesehenen Meßort geführt wird und daß die Rasterkraft-Sonde über dem Meßort an die integrierte Schaltung herangefahren wird, solange, bis die Kraft, die zwischen der Rasterkraft-Sonde und der integrierten Schaltung wirkt, einen vorgegebenen Wert erreicht.

Bei der Suche nach defekten Stellen auf einer integrierten Schaltung werden unter anderem Leiterbahnen der Schaltung mit einer Ladung versehen, die nach einer gewissen Zeit wieder abgegriffen wird. Hat sich die Ladungsmenge zwischenzeitlich verändert, so ist dies ein Hinweis auf eine defekte Stelle auf der integrierten Schaltung. Zum Beaufschlagen einer Leiterbahn einer integrierten Schaltung mit einer elektrischen Ladung mit Hilfe einer erfindungsgemäßen Feldemissions-Sonde ist vorgesehen, daß die Feldemissions-Sonde an feuchter Luft betrieben oder mit einem wasserhaltigen Film überzogen wird, daß die Feldemissions-Sonde der zu ladenden Leiterbahn der integrierten Schaltung angenähert und durch Anlegen einer Spannung an die Feldemissions-Sonde OH⁻-Ionen aus dem Film ausgesondert werden und zu der Leiterbahn übergehen, so daß die Leiterbahn negativ elektrisch aufgeladen wird.

Durch die Verwendung von ionisierten Wassermolekülen kann die Polarität, mit der die Leiterbahn geladen wird, gewählt werden. Um mehrere Leiterbahnen gleichzeitig laden zu können, ohne daß gegenseitige Beeinflussungen auftreten, die das Meßergebnis verfälschen, ist vorgesehen, daß die Feldemissions-Sonde nach dem Laden einer Leiterbahn mit einer negativen Ladung zu einer nächsten Leiterbahn bewegt und mit einer umgekehrten Spannung beaufschlagt wird, wodurch die Leiterbahn durch aus dem Film ausgesonderte H30⁺-Ionen positiv elektrisch aufgeladen wird und so fort, so daß benachbarte Leiterbahnen mit unterschiedlichen Polaritäten geladen werden.

Um Informationen über die Zusammensetzung der Leiterbahnen der zu überprüfenden Schaltung zu erhalten, ist bei einer Weiterbildung der Erfindung vorgesehen, daß die Rasterkraft-Sonde eine optische Nahfeld-Spitze (SNOM) aufweist, daß Licht aus der SNOM-Spitze (Scanning-Nearfiled-Optical Microscope) gesandt wird und daß mit dem Licht Photoelektronen aus dem Werkstoff einer benachbarten Leiterbahn ausgelöst werden, so daß durch Spektroskopie der austretenden Strahlung auf den Werkstoff der Leiterbahn rückgeschlossen werden kann. Eine derartige Sondenspitze ist ebenfalls komplett mit dem erfindungsgemäßen Aufwachsverfahren herstellbar.

Ein Ausführungsbeispiel eines erfindungsgemäßen Testkopfes ist in der Zeichnung anhand mehrerer Figuren dargestellt und nachfolgend beschrieben. Es zeigt:
- Fig. 1: einen erfindungsgemäßen Testkopf und
- Fig. 2: denselben Testkopf mit einer Verstärkerschaltung.

Der pyramidenförmige Träger 2 aus Siliziumnitrit ist in dem Ausführunsbeispiel an dem Kantilever 1 eines Rasterelektronenmikroskops befestigt. Auf dem Träger 2 sind je eine Rasterkraft-Sonde 3, eine kapazitive Sonde 4, eine Feldemissions-Sonde 5 und eine Induktionsschleife 6 so angeordnet, daß sie schräg zu einer zentralen Stelle über dem Träger 2 weisen. Die Sonden sind durch elektronenstrahlinduzierte Deposition auf den Träger aufgebracht worden.

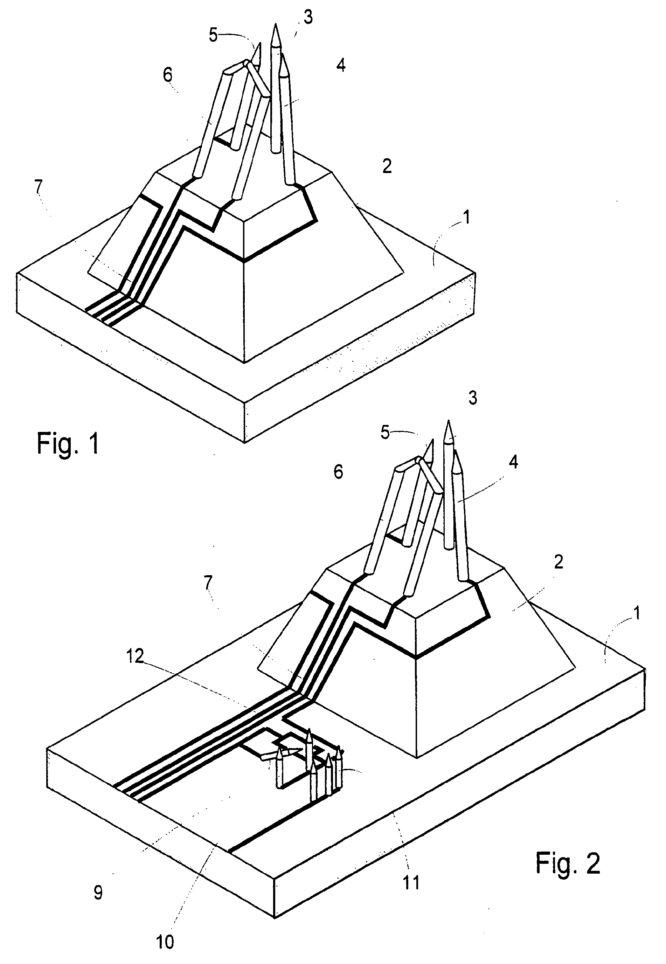

Zur Verstärkung der von den Sonden 4 bis 6 abgegebenen Signale ist eine Verstärkerschaltung in die Verbindungsleitungen 7 der Sonden 4 bis 6 eingebaut. Die gesamte Anordnung ist inklusive einer Verstärkerschaltung 8 zur Verstärkung der Signale der Feldemissions-Sonde 4 in Fig. 2 wiedergegeben. Es bezeichnet 9 die Kathode einer Verstärker-Röhre, 10 deren Gitter und 11 deren Anode. Die Kathode 9 und die Gitter 10 sind über einen Widerstand 12 parallelgeschaltet. Die gesamte Struktur ist mit dem erfindungsgemäß verwendeten Aufwachsverfahren auf das Trägermaterial 1, 2 aufgebaut, um alle Elemente mit derartig geringen Abmessungen herstellen zu können.

## Patentansprüche

1. Testkopf für ein Rastersondenmikroskop zum berührungslosen Prüfen von integrierten elektronischen Schaltungen, **dadurch gekennzeichnet, dass** eine Gruppe von durch dreidimensionale additive Lithographie hergestellten Sonden (3 bis 6) mit wenigstens einem elektrisch isolierenden, zugespitzt endenden Körper (3) als Rasterkraft-Sonde zur Abtastung der Topographie der Schaltung, mit wenigstens einer kapazitiven Sonde (4) zur Messung von Signalimpulsen und mit wenigstens einer magnetfeld-empfindlichen Sonde (6) zur Messung von elektrischen Strömen, sowie mit wenigstens einem spitz zulaufenden leitenden Körper (5) als Feldemissions-Sonde auf einem Träger (2) angeordnet ist, dass die Sonden (3 bis 6) auf eine zentral über der Sondengruppe gelegene Stelle gerichtet sind und dass das Fuβende der leitenden kapazitiven Sonde (4), die leitende Feldemissionssonde (5) und die leitende magnetfeld-empfindliche Sonde (6) zum Anschluss an eine Messschaltung mit Leiterstrukturen auf dem Träger (2) verbunden sind.

2. Testkopf nach Anspruch 1, **dadurch gekennzeichnet, dass** die Rasterkraft-Sonde (3) die anderen Sonden (4, 5, 6)überragt.

3. Testkopf nach Anspruch 1 oder 2, **dadurch gekennzeichnet, dass** die Körper der Sonden (3 bis 6) einen größten Durchmesser in der Größenordnung 100 nm aufweisen.

4. Testkopf nach einem der vorhergehenden Ansprüche, **dadurch gekennzeichnet, dass** die Spitzen der spitz zulaufenden Sonden (3 bis 6) kegelstumpfförmig sind, einen Öffnungswinkel in der Größenordnung von 10° und einen Spitzendurchmesser in der Größenordnung von 10 nm aufweisen.

5. Testkopf nach einem der vorhergehenden Ansprüche, **dadurch gekennzeichnet, dass** die Sonden (3 bis 6) Längen in der Größenordnung von 1 µm aufweisen.

6. Testkopf nach einem der vorhergehenden Ansprüche, **dadurch gekennzeichnet, dass** der Träger (2) in seinen Hauptausdehnungsrichtungen Abmessungen in der Größenordnung von 1 µm aufweist.

7. Testkopf nach einem der vorhergehenden Ansprüche, **dadurch gekennzeichnet, dass** eine Verstärkerschaltung mit in unmittelbarer Nachbarschaft der Sonden (3 bis 6) in dreidimensionaler Nanolithographie ausgeführten elektrischen Verstärkerröhren zur Verstärkung der von den Sonden (3 bis 6) abgegebenen Messsignale auf dem Träger (2) angeordnet ist.

8. Testkopf nach einem der vorhergehenden Ansprüche, **dadurch gekennzeichnet, dass** der Träger (2) ein Pyramidenstumpf aus Siliziumnitrit ist.

9. Testkopf nach einem der vorhergehenden Ansprüche, **dadurch gekeanzeichant,** dass die Rasterkraft-Sonde (3) aus einem hochelastischen Material besteht.

10. Testkopf nach einem der vorhergehenden Ansprüche, **dadurch gekennzeichnet, dass** die kapazitive Sonde (4) einen elektrisch leitfähigen Kern und ein isolierendes Endstück am Fußende der Sonde (4) aufweist.

11. Testkopf nach einem der vorhergehenden Ansprüche, **dadurch gekennzeichnet, dass** die Feldemissions-Sonde (5) einen elektrisch leitfähigen Kern und eine leitfähige Spitze sowie einen isolierenden Mantel aufweist, aus dem die leitfähige Spitze herausragt.

12. Testkopf nach einem der vorhergehenden Ansprüche, **dadurch gekennzeichnet, dass** die magnetfeld-empfindliche Sonde (6) als eine, an ihren beiden Enden mit dem Träger (2) verbundene, als aufrecht stehender Bogen ausgeführte Induktionsspule aus elektrisch leitfähigem Material ausgebildet ist.

13. Testkopf nach Anspruch 1, **dadurch gekennzeichnet, dass** die magnetfeld-empfindliche Sonde (6) durch einen magnetoresistiven aufrecht stehenden Bogen aus in wechselnder Folge schichtförmig angeordneten Materialien, vorzugsweise Kupfer und Kobalt, gebildet wird, welcher an seinen beiden Enden mit dem Träger (2) verbunden ist.

14. Testkopf nach einem der vorhergehenden Ansprüche, **dadurch gekennzeichnet, dass** der Höhenabstand der Feldemissions-Sonde (5) zu der Rasterkraftsonde (3) gerade so bemessen ist, dass bei Berührung der integrierten Schaltung am Messort durch die Rasterkraft-Sonde (3) durch eine an die Feldemissions-Sonde (5) angelegte Spannung gerade kein oder ein definierter Feldemissions-Strom fließt.

15. Testkopf nach Anspruch 1, **dadurch gekennzeichnet, dass** die Sonden (3 bis 6) ferner wenigstens eine lichtleitende Sonde zur Übertragung optischer Nahfelder zur Ein- und Auskopplung optischer Signale an der Schaltung sowie zur spektrometrischen Ermittlung des Schaltungsmaterials aufweist, welche aus einem lichtleitenden Material besteht und von einer lichtreflektierenden Schicht umgeben ist.

16. Testkopf nach einem der vorhergehenden Ansprüche, **gekennzeichnet durch** den Einbau in ein Rastersondenmikroskop, wobei zur Überprüfung einer integrierten Schaltung der Testkopf derart justiert ist, dass die Rasterkraft-Sonde (3) berührungslos über die integrierte Schaltung bis zum vorgesehenen Messort geführt und über den Messort an die integrierte Schaltung solange herangefahren ist, bis die zwischen der Rasterkraft-Sonde (3) und der integrierten Schaltung wirkende Kraft einen vorgegebenen Wert erreicht hat.

17. Verfahren zum berührungslosen Prüfen von integrierten elektronischen Schaltungen mit einem Testkopf für ein Rastersondenmikroskop nach einem der vorangehenden Ansprüche, **dadurch gekennzeichnet, dass** die zu prüfende integrierte elektronische Schaltung mit einer elektrischen Ladung mit Hilfe des Testkopfes versehen wird, wofür die Feldemissions-Sonde (5) des Testkopfes an feuchter Luft betrieben oder mit einem wasserhaltigen Film überzogen wird und die Feldemissions-Sonde (5) der zu ladenden Leiterbahn der integrierten Schaltung angenähert und durch Anlegen einer Spannung an die Feldemissions-Sonde (5) OH⁻-Ionen aus dem Film ausgesondert werden und zu der Leiterbahn der zu prüfenden elektronischen Schaltung übergeben werden, so dass die Leiterbahn elektronisch aufgeladen wird, und nach einem Zeitraum die Ladung gemessen wird.

18. Verfahren nach Anspruch 17, **dadurch gekennzeichnet, dass** die Feldemissions-Sonde (5) des Testkopfes nach dem Laden einer Leiterbahn mit einer negativen Ladung zu einer nächsten Leiterbahn bewegt und mit einer umgekehrten Spannung beaufschlagt wird, wodurch die Leiterbahn durch aus dem Film ausgesonderte H30⁺-Ionen positiv elektrisch aufgeladen wird und so fort, sodass benachbarte Leiterbahnen mit unterschiedlichen Polaritäten geladen werden.

## Claims

1. A scanning probe microscope test head for non-contact integrated electronic circuit testing **characterized in that** arranged on a carrier (2) is a group of probes (3 to 6) obtained through three-dimensional additive lithography, including at least one electrically insulating body (3) having a tapered end which constitutes a scanning force probe for scanning the circuit topography, at least one capacitance probe (4) for measuring signal pulses, and at least one magnetic field sensitive probe (6) for measuring electric currents, as well as at least one tapering conductive body (5) which constitutes a field emission probe, wherein said probes (3 to 6) are directed to a point located centrally above said group of probes and wherein the bottom of the conductive capacitance probe (4), the conductive field emission probe (5) and the conductive magnetic field sensitive probe (6) are connected to conductor structures on said carrier (2) for connection to a measuring circuit.

2. A test head of claim 1 **characterized in that** said scanning force probe (3) towers above said other probes (4, 5, 6).

3. The test head of claims 1 or 2 **characterized in that** the largest diameter of the bodies of said probes (3 to 6) is approx. 100 nm.

4. The test head of one of the preceding claims **characterized in that** the tips of the tapering probes (3 to 6) are truncated, that they have an aperture angle of approx. 10° and a tip diameter of approx. 10 nm.

5. The test head of one of the preceding claims **characterized in that** the lengths of said probes (3 to 6) are of the order of 1 µm.

6. The test head of one of the preceding claims **characterized in that** the dimensions of said carrier (2) in its main extension directions are of the order of 1 µm.

7. The test head of one of the preceding claims **characterized in that** arranged on said carrier (2) is an amplifier circuit including electrical amplifier tubes, obtained through three-dimensional nanolithography, in the immediate vicinity of said probes (3 to 6) for amplifying the measuring signals output by said probes (3 to 6).

8. The test head of one of the preceding claims **characterized in that** said carrier (2) is a truncated pyramid made of silicon nitrite.

9. The test head of one of the preceding claims **characterized in that** said scanning force probe (3) is made from a highly elastic material.

10. The test head of one of the preceding claims **characterized in that** said capacitance probe (4) includes an electrically conductive core and an insulating end portion at the bottom end of said probe (4).

11. The test head of one of the preceding claims **characterized in that** said field emission probe (5) includes an electrically conductive core and a conductive tip as well as an insulating sleeve from which said conductive tip projects.

12. The test head of one of the preceding claims **characterized in that** said magnetic field sensitive probe (6) is formed as an induction coil made from electrically conductive material which has its two ends connected to said carrier (2) and is in the form of an upright arch.

13. The test head of claim 1 **characterized in that** said magnetic field sensitive probe (6) is in the form of a magnetoresistive upright arch made from alternating layers of materials, preferably copper and cobalt, said arch having its two ends connected to said carrier (2).

14. The test head of one of the preceding claims **characterized in that** the distance in height between said field emission probe (5) and said scanning force probe (3) has been chosen just so that when the IC is contacted by the scanning force probe (3) at the measuring point through a voltage applied to said field emission probe (5), just no field emission current or a defined field emission current will flow.

15. The test head of claim 1 **characterized in that** said probes (3 to 6) furthermore include at least one light guiding probe for transmitting optical near-fields for inputting and outputting optical signals at the circuit as well as for spectrometrically determining the circuit material, which light guiding probe is made from a light guiding material and is surrounded by a light reflecting layer.

16. The test head of one of the preceding claims **characterized by** its incorporation in a scanning probe microscope, wherein for checking an integrated circuit the test head has been adjusted such that said scanning force probe (3) will pass over said integrated circuit to the intended measuring point without contacting it, and above said measuring point will be advanced to the integrated circuit until the force acting between said scanning force probe (3) and said integrated circuit has reached a predetermined value.

17. A method for non-contact IC testing using a scanning probe microscope test head as claimed in one of the preceding claims **characterized in that** the electronic IC to be tested will be electrically charged by means of said test head, for which purpose said field emission probe (5) of said test head will be operated in humid air or coated with an aqueous film and said field emission probe (5) will be brought closer to the IC strip conductor to be charged and OH" ions will become separated from said film and transferred to the strip conductor of the electronic circuit to be tested when a voltage is applied to said field emission probe (5), thus causing said strip conductor to become electronically charged, which charge will be measured after a certain period of time.

18. The method of claim 17 **characterized in that**, having negatively charged a strip conductor, said field emission probe (5) of said test head will be moved to a subsequent strip conductor and a reverse charge will be applied thereto, which will cause said strip conductor to become positively charged with H30³ ions separated from said film, and so on, resulting in adjacent strip conductors to be charged with different polarities.

## Revendications

1. Tête de contrôle pour microscope à balayage pour tester sans contact des circuits électroniques intégrés, **caractérisée par le fait que** sur un support (2) est placé un groupe de sondes (3 à 6) réalisées par lithographie additive tridimensionnelle qui comprend au moins un corps isolant électrique se terminant en pointe (3) qui sert de sonde à balayage pour l'analyse de la topographie du circuit, au moins une sonde capacitive (4) pour la mesure d'impulsions de signal, au moins une sonde sensible aux champs magnétiques (6) pour la mesure de courants électriques, et au moins un corps conducteur se terminant en pointe (5) qui sert de sonde d'émission de champ, que les sondes (3 à 6) sont dirigées sur un endroit situé au centre au-dessus du groupe de sondes, et que le pied de la sonde capacitive conductrice (4), la sonde conductrice d'émission de champ (5) et la sonde conductrice sensible aux champs magnétiques (6) sont, pour leur connexion à un circuit de mesure, joints à structures conductrices prévus sur le support (2).

2. Tête de contrôle selon la revendication 1, **caractérisée par le fait que** la sonde à balayage (3) s'élève plus haut que les autres sondes (4, 5, 6).

3. Tête de contrôle selon l'une des revendications 1 et 2, **caractérisée par le fait que** le corps des sondes (3 à 6) présente un diamètre maximal de l'ordre de 100 nm.

4. Tête de contrôle selon l'une des revendications précédentes, **caractérisée par le fait que** la pointe des sondes se terminant en pointe (3 à 6) est tronconique et présente un angle d'ouverture de l'ordre de 10° et un diamètre de l'ordre de 10 nm.

5. Tête de contrôle selon l'une des revendications précédentes, **caractérisée par le fait que** les sondes (3 à 6) présentent une longueur de l'ordre de 1 µm.

6. Tête de contrôle selon l'une des revendications précédentes, **caractérisée par le fait que** le support (2) présente dans ses directions principales d'extension des dimensions de l'ordre de 1 µm.

7. Tête de contrôle selon l'une des revendications précédentes, **caractérisée par le fait que** sur le support (2) est placé un circuit amplificateur comportant des tubes amplificateurs électriques réalisés par nanolithographie tridimensionnelle à proximité immédiate des sondes (3 à 6) pour l'amplification des signaux de mesure émis par les sondes (3 à 6).

8. Tête de contrôle selon l'une des revendications précédentes, **caractérisée par le fait que** le support (2) est un tronc de pyramide en nitrite de silicium.

9. Tête de contrôle selon l'une des revendications précédentes, **caractérisée par le fait que** la sonde à balayage (3) est constituée d'une matière à haute élasticité.

10. Tête de contrôle selon l'une des revendications précédentes, **caractérisée par le fait que** la sonde capacitive (4) présente une âme conductrice et, à son pied, une extrémité isolante.

11. Tête de contrôle selon l'une des revendications précédentes, **caractérisée par le fait que** la sonde d'émission de champ (5) présente une âme conductrice, une pointe conductrice et une gaine isolante d'où la pointe conductrice fait saillie.

12. Tête de contrôle selon l'une des revendications précédentes, **caractérisée par le fait que** la sonde sensible aux champs magnétiques (6) est constituée d'une bobine d'induction en matière conductrice réalisée sous forme d'arc dressé et jointe à ses deux extrémités au support (2).

13. Tête de contrôle selon la revendication 1, **caractérisée par le fait que** la sonde sensible aux champs magnétiques (6) est formée d'un arc magnétorésistif dressé qui est constitué de matières, de préférence de cuivre et de cobalt, disposées en couches alternées et est joint à ses deux extrémités au support (2).

14. Tête de contrôle selon l'une des revendications précédentes, **caractérisée par le fait que** la distance en hauteur de la sonde d'émission de champ (5) à la sonde à balayage (3) est exactement fixée de façon que lorsque la sonde à balayage (3) touche le circuit intégré à l'emplacement de mesure, une tension appliquée à la sonde d'émission de champ (5) ne produise pas de passage de courant d'émission de champ ou produise le passage d'un courant d'émission de champ défini.

15. Tête de contrôle selon la revendication 1, **caractérisée par le fait que** les sondes (3 à 6) comprennent en outre au moins une sonde conduisant la lumière pour la transmission de champs optiques proches pour le couplage et le découplage de signaux optiques sur le circuit et pour la détermination spectrométrique de la matière du circuit, laquelle sonde est constituée d'une matière conduisant la lumière et est entourée d'une couche réfléchissant la lumière.

16. Tête de contrôle selon l'une des revendications précédentes, **caractérisée par** son montage dans un microscope à balayage, cette tête étant, pour le test d'un circuit intégré, ajustée de façon telle que la sonde à balayage (3) soit déplacée sans contact sur le circuit intégré jusqu'à l'emplacement de mesure prévu et, à cet emplacement, approchée du circuit intégré jusqu'à ce que la force qui agit entre la sonde à balayage (3) et le circuit intégré atteigne une valeur fixée.

17. Procédé de test sans contact de circuits électroniques intégrés avec une tête de contrôle pour microscope sonde à balayage selon l'une des revendications précédentes, **caractérisé par le fait qu'**on pourvoit le circuit électronique intégré à contrôler d'une charge électrique à l'aide de la tête d'essai, ce pour quoi on fait fonctionner la sonde d'émission de champ (5) de la tête de contrôle à l'air humide ou revêt cette sonde d'un film retenant l'eau, et approche la sonde d'émission de champ (5) de la piste conductrice à charger du circuit intégré et, en appliquant une tension à la sonde d'émission de champ (5), détache des ions OH⁻ du film et les transmet à la piste conductrice du circuit électronique à contrôler, de sorte qu'on charge électroniquement la piste conductrice, et, après un certain laps de temps, on mesure la charge.

18. Procédé selon la revendication 17, **caractérisé par le fait qu'**après la charge d'une piste conductrice avec une charge négative, on déplace la sonde d'émission de champ (5) de la tête de contrôle jusqu'à une piste conductrice suivante et y applique une tension inverse, de sorte qu'on charge positivement la piste conductrice avec des ions H₃O⁺ détachés du film, et ainsi de suite, de sorte qu'on charge les pistes conductrices voisines avec des polarités différentes.
